# EUROPÄISCHE PATENTANMELDUNG

(11) **EP 1 347 497 A2**
(43) Veröffentlichungstag der Anmeldung: **24.09.2003**
(21) Anmeldenummer: 03004416.8
(22) Anmeldetag: 27.02.2003
(51) Int. Cl.: H01L 21/00

(54) **Hordenhalter für Halbleiterscheiben**

(30) Priorität: 08.03.2002 DE 10210271
(71) Anmelder: Infineon Technologies AG, 81669 München (DE)
(72) Erfinder: Hohenwarter, Erwin, 9500 Villach (AT); Rauter, Henry, 9500 Villach (AT)
(74) Vertreter: Bickel, Michael

(57) **Zusammenfassung**

Die Erfindung betrifft eine Hordenanordnung mit einer Waferhorde zur Aufnahme und Transport einer Vielzahl von Wafern für nasschemische Prozesse in der Halbleitertechnologie, die ein Gehäuse aufweist, welches zwei miteinander durch Stege verbundene, entsprechend der Anzahl der vorgesehenen Wafer an sich gegenüberliegenden Seiten mit senkrechten, äquidistanten Führungsschlitzen versehene Gehäusewände umfasst, mit Distanzhaltern, die jeweils bei der mit Wafern beladenen Waferhorde derart zwischen die Wafer bewegbar sind, dass benachbarte Wafer von einem Distanzhalter beabstandet und gestützt sind. Die Erfindung betrifft ferner einen Hordenhalter zur Aufnahme einer Waferhorde sowie ein Verfahren zum Fixieren und Stützen von in einer Waferhorde angeordneter Wafer.

## Beschreibung

Die Erfindung betrifft eine Hordenanordnung mit einer Waferhorde, einen Hordenhalter zur Aufnahme einer Waferhorde sowie ein Verfahren zum Fixieren und Stützen von in einer Waferhorde angeordneter Wafer.

Bei der halbleitertechnologischen Prozessierung von Wafernbeispielsweise in Implantationsanlagen, Sputteranlagen, Lithographieanlagen, nasschemischen Anlagen, etc. - werden eine Vielzahl von Wafern in einer eigens dafür vorgesehenen Waferhorde aufbewahrt und transportiert. Ein solcher Waferhorden weist ein Gehäuse mit einer nach oben hin offene Ausnehmung auf. Das Gehäuse der Waferhorde besteht aus zwei durch stirn- und rückseitige Begrenzungsplatten miteinander verbundene, geschlitzte Verbindungsteilen. Eine solche Waferhorde ist beispielsweise in dem deutschen Gebrauchsmuster G 680 29 074 U1 sowie in dem deutschen Gebrauchsmuster G 93 14 849 U1 beschrieben.

In der modernen Halbleitertechnologie, insbesondere bei Leistungshalbleiterbauelementen, wie Leistungs-MOSFETs, IGBTs, Thyristoren und dergleichen, geht die Tendenz hin zu einer Reduzierung der Waferdicke, um dadurch den Einschaltwiderstand R_{ON} des Halbleiterbauelementes zu reduzieren und um damit einhergehend die Durchlass- und Schaltverluste des Halbleiterbauelementes zu optimieren. Dünne Wafer, die eine Dicke von kleiner 150 µm aufweisen, sind allerdings sehr empfindlich bezüglich deren Prozessierung und können bei unsachgemäßer Handhabung leicht brechen. Die Wafer einer Waferhorde sollten dort so angeordnet sein, dass eine möglichst gleichmäßige Prozessierung aller Wafer der Horde sowie eine möglichst gleichmäßige Prozessierung über die gesamte Waferoberfläche gewährleistet ist. Die Wafer einer Waferhorde sollten also im wesentlichen äquidistant bezüglich deren Oberflächen, d. h. im wesentlichen parallel nebeneinander im Gehäuse der Waferhorde angeordnet sein. Dies setzt jedoch voraus, dass die dünnen Wafer eine ausreichende Steifigkeit bzw. eine im wesentlichen planare, ebene Oberfläche aufweisen. Problematisch daran ist jedoch, dass insbesondere bei Verwendung sehr dünner Wafer mit Waferdicken im Bereich von kleiner 150 µm bei gleichzeitig immer größer werdenden Waferdurchmessern eine solche planare Oberfläche und somit eine ausreichende Steifigkeit nicht mehr gewährleistet werden kann. Die Ursache dafür liegt daran, dass der Wafer nach dem Dünnschleifen bzw. Dünnätzen auf die erforderliche Dicke statt der erforderlichen Steifigkeit eine mehr oder weniger stark gewellte, gebogene oder leicht verdrehte (Torsion) Oberfläche aufweist. Beim Anordnen solcher Wafer im Gehäuse der Waferhorde ist jedoch ein äquidistanter Abstand zweier benachbarter Wafer nicht mehr gegeben.

Besonders gravierend ist dieser Effekt bei außerordentlich dünn geätzten Wafern im Bereich von etwa 70 µm. In diesem Fall ist der Wafer so dünn, dass er ähnlich einem Blatt Papier biegbar ist. Werden solche biegbaren Wafer in die Nuten bzw. Schlitze der Waferhorde eingefügt, dann sinken sie aufgrund ihres Eigengewichts innerhalb der Nut- bzw. Schlitzbreite in sich zusammen. Die geforderte Steifigkeit ist bei solch dünnen Wafern also nicht mehr gewährleistet. Aufgrund der erhöhten Biegsamkeit kann es vielmehr sogar auch zu Berührungen benachbarter Wafer kommen. Werden dessen ungeachtet herkömmliche Hordenanordnungen zur Prozessierung dünner Wafer verwendet, kann eine einheitliche Prozessierung der dünnen Wafer nicht mehr gewährleistet werden. Zudem führt eine Berührung benachbarter Wafer zu Ausfällen von Halbleiterbauelementen an den Berührungspunkten, da die Wafer dort nicht prozessiert wurden.

Um dennoch zu gewährleisten, dass bei der nasschemischen Prozessierung sämtliche Oberflächenbereiche der Wafer gleichmäßig prozessiert werden, müssen sämtliche Prozesse, vor allem die Trocknungsprozesse, wiederholt durchgeführt werden, wodurch die Prozessierung sehr lange dauert. Diese zeitintensive Prozessierung ist mit modernen Fertigungstechniken nicht mehr zu vereinbaren, da die theoretisch mögliche Kapazität einer Fertigungslinie dadurch bei weitem nicht ausgenutzt wird. Zudem leidet die Wirtschaftlichkeit der so prozessierten Halbleiterbauteile, was deren technische Weiterentwicklung massiv bremst. Daraus folgt jedoch, dass die nasschemische Prozessierung dünner Wafer sich mit herkömmlichen Waferhorden - vor allem bei einer aus Kostengründen anzustrebenden hohen Ausbeute - sich nicht mehr zufriedenstellend bewerkstelligen lässt.

Der vorliegenden Erfindung liegt daher die Aufgabe zugrunde, eine Anordnung und ein Verfahren zur Aufnahme dünner Wafer für nasschemische Prozesse bereitzustellen, bei der die einzelnen dünnen Wafer weitestgehend unabhängig voneinander prozessiert werden.

Die anordnungsbezogene Aufgabe wird erfindungsgemäß durch eine Hordenanordnung mit den Merkmalen des Patentanspruchs 1 sowie einen Hordenhalter mit den Merkmalen des Patentanspruchs 15, die verfahrensbezogene Aufgabe durch ein Verfahren mit den Merkmalen des Patentanspruchs 16 gelöst.

Vorteilhafte Ausgestaltungen und Weiterbildungen der Erfindung sind Gegenstand der Unteransprüche.

Erfindungsgemäß ist die Hordenanordnung mit Distanzhaltern ausgestattet, mittels der die verbogenen, dünnen Wafer in definierten Abstand zueinander gehalten werden können. Zudem werden die Wafer von den Distanzhaltern auch gestützt. Die Wafer stehen als in äquidistantem Abstand zueinander, dass heißt weitestgehend parallel und senkrecht in der Waferhorde. Eine Berührung der einzelnen Wafer, selbst wenn es sich um gewellte oder gebogene Wafer handelt, unterbleibt hier. Die einzelnen Wafer können somit ungeachtet deren Dicke gleichmäβig prozessiert werden, ohne dass ein zeitaufwendiges Nachprozessieren erforderlich wäre.

Erfindungsgemäß ist ferner - insbesondere als Bestandteil der Hordenanordnung - ein Hordenhalter vorgesehen. Der Hordenhalter, der typischerweise aus einem feststehende Stativ, an dem die Schwenkvorrichtung drehbar gelagert ist, besteht, dient der Aufnahme mindestens einer Waferhorde für nasschemische Prozesse.

Um die Distanzhalter bzw. Stifte des Kammes weitestgehend ohne Berührung zwischen benachbarte Wafer anzuordnen, ist eine Schwenkvprrichtung vorgesehen, mittels der die Distanzhalter beim Be- und Entladevorgang der Waferhorde in eine Position außerhalb der Waferhorde derart geschwenkt werden, dass ein ungehindertes Be- und Entladen der Waferhorde mit Wafern möglich wird. Bei einer mit Wafern beladenen Waferhorde lassen sich ferner die Distanzhalter zwischen benachbarte Wafer schwenken. Eine solche Schwenkvorrichtung, die die Distanzhalter zwischen die Wafer bewegt, ist bislang weder für sich bekannt noch in Kombination mit eine Waferhorde. Lediglich in dem deutschen Gebrauchsmuster G 93 14 849 U1 ist ein Hordenhalter zum Transportieren einer Waferhorde angegeben, der jedoch die Waferhorde zum Transportieren hält, nicht jedoch das Problem der Stabilität bzw. der Fixierung der Wafer innerhalb der Waferhorde löst.

Die Schwenkvorrichtung weist einen optimierten Bewegungsmechanismus zum Ein- und Herausschwenken der Distanzhalter in bzw. aus der Horde auf. Die Schwenkvorrichtung weist zu diesem Zweck drei um jeweils drei Bewegungsachsen drehbare Teile auf, über die die Distanzhalter so zwischen die verbogenen Dünnwafer geführt wird, dass während der Schwenkbewegungen dieser Teile in die Waferhorde hinein oder aus ihr heraus eine Berührung der Wafer durch die Distanzhalter weitestgehend vermieden wird. Vorteilhafterweise sind die Distanzhalter Betsandteil eines dieser Teile. Bei der weiteren Bewegung der Distanzhalter in die Lage, in der die Wafer bearbeitet (prozessiert) werden, kann aufgrund einer vorteilhaften Ausgestaltung des Distanzhalters eine Beschädigung des Wafers auf ein Minimum reduziert werden.

In einer vorteilhaften Ausgestaltung ist die Schwenkvorrichtung von der Waferhorde abnehmbar vorgesehen. Mit dieser zusätzlichen Funktionalität können herkömmliche Horden zum nasschemischen Prozessieren dünner Wafer herangezogen werden. Solche herkömmlichen Gehäuse weisen typischerweise eine Schlitzbreite von 4 mm auf und sind dazu ausgelegt, bis zu 25 Wafer aufzunehmen. Bei Verwendung einer abnehmbaren Schwenkvorrichtung können die Horden mittels dieser Schwenkvorrichtung in ein nasschemisches Bad, eine Trocknungskammer, etc. transportiert werden und anschließend die Schwenkvorrichtung abgenommen werden, so dass die Waferhorde ungehindert prozessiert werden kann.

In einer vorteilhaften Ausgestaltung ist eine Antriebseinheit sowie eine programmgesteuerte Einheit- z. B. ein Mikroprozessor oder ein Computer - vorgesehen. Dadurch können die Elemente der Bewegungsvorgang der Schwenkvorrichtung automatisiert werden und beispielsweise programmgesteuert ablaufen.

Der Distanzhalter hat vorteilhafterweise die Form eines Kammes. Der Kamm weist spezielle Kammzähne bzw. Stifte auf. Die Kammstifte aus gezogenem Quarzglas fungieren als Distanzhalter und Stütze benachbarter Wafer, dass eine Beschädigung der Wafer bzw. eine Berührung benachbarter Wafer unterbleibt.

Als Material für die Distanzhalter ist in einer vorteilhaften Ausgestaltung Quarzglas - insbesondere gezogenes Quarzglas-vorgesehen. Der Vorteil von Distanzhalter aus gezogenem Quarzglas liegt insbesondere in der größeren Härte und besseren Oberflächenqualität verglichen mit geschliffenen Quarzglasdistanzhaltern, die eine eher raue Oberfläche aufweist.

Berührt ein Distanzhalter aus gezogenem Quarzglas einen Dünnwafer, dann ist die Reibung aufgrund der glatten und sehr harten Oberfläche so gering, dass eine Beschädigung des Wafers auf ein Minimum reduziert wird. Darüber hinaus können die scharfen Kanten der Dünnwafer sich nicht so leicht in die Distanzhalter einschneiden, was zu einer verlängerten Lebensdauer der Distanzhalter führt.

Die so hergestellten Distanzhalter weisen eine sehr niedrige Oberflächenrauhigkeit (Ra) von beispielsweise weniger als 0,012 µm, auf. In einer sehr vorteilhaften Ausgestaltung sind die Distanzhalter (Kammstifte) derart hergestellt, dass die Oberflächenrauhigkeit weniger als 0,006 µm beträgt.

Die Stifte des Distanzhalter weisen in einer vorteilhaften Ausgestaltung eine spitze Form auf. Die Stifte des Distanzhalter weisen in einer weiteren vorteilhaften Ausgestaltung eine konische Form auf. Durch die spitze und/oder konische Form sowie die hohe Oberflächengüte der gezogenen Distanzhalter (Quarzstifte) wird die Reibung beim Kontakt dieser Distanzhalter mit dem Waferrand so minimiert, dass dadurch keine Beschädigung der Scheiben erfolgt. Um eine gleich gute Qualität zu erreichen, können herkömmliche geschliffene und feuerpolierte Stifte von Distanzhaltern (Kammstifte) nur unter sehr hohem Aufwand hergestellt werden.

Durch die erfindungsgemäße Schwenkvorrichtung wird mithin gewährleistet, dass die Wafer am Ende der Schwenkbewegung lediglich von der Oberfläche der konischen Stifte des Quarzkammes berührt werden, nicht jedoch von den Stiftspitzen bzw. den schwenkbar gelagerten Teilen der Schwenkvorrichtung. Dadurch wird verhindert, dass die Distanzhalter bei Berührung mit dem Wafer an diesem abrutschen und dadurch den Wafer beschädigen. Zudem wird dadurch gewährleistet, dass die scharfkantigen Wafer sich nicht in die Distanzhalter einschneiden können, was unter Umständen zu Scheibenbrüchen führen könnte bzw. wodurch es zu einer Beschädigung der Distanzhalter kommen könnte.

Die erfindungsgemäße Hordenanordnung bzw. das erfindungsgemäße Verfahren ist zur Aufnahme einer Horde dünner Wafer für nasschemische Prozesse vorgesehen. Unter einem dünnen Wafer ist hier ein Wafer mit einer Dicke kleiner 200 µm, vorteilhafterweise von kleiner 150 µm, zu verstehen. Besonders vorteilhaft ist die vorliegende Erfindung jedoch bei sehr dünnen, biegsamen Wafern im Bereich von etwa 80 µm und dünner. Die erfindungsgemäße Anordnung bzw. das erfindungsgemäß Verfahren eignet sich also insbesondere für sogenannte unstabilisierte Wafer. Unter unstabilisierten Wafern sind solche Wafer zu verstehen, bei denen aufgrund des Verhältnisses von Waferdicke zu Waferdurchmesser eine hohe Planarität der Oberfläche nicht mehr gewährleistet ist. Unstabilisierten Wafern ist typischerweise das Problem einer gewellten, verbogenen oder leicht verdrehten Oberfläche inhärent. Der besondere Vorteil der vorliegenden Erfindung besteht insbesondere darin, dass auch solche unstabilisierte, dünne Wafer mittels einer herkömmlichen Waferhorde nasschemisch prozessiert werden können.

Als Material der Waferhorde sowie des Hordenhalters ist typischerweise Polyetheretherketon (PEEK) vorgesehen. PEEK-Material weist eine sehr hohe Gebrauchstemperatur bis zu 240°C auf. Bis zu diesem Temperaturbereich weist PEEK eine ausgezeichnete chemische und Hydrolysebeständigkeit sowie eine sehr hohe mechanische Festigkeit und Ermüdungsfestigkeit auf. PEEK weist gegenüber anderen Materialien mit denselben mechanischen, chemischen und physikalischen Eigenschaften den besonderen Vorteil einer exakten Zerspanbarkeit auf, was insbesondere für die Herstellung der Waferhorde und des Hordenhalters, bei denen eine sehr hohe Präzision gefordert ist, einen entscheidenden Vorteil bietet. Dadurch wird auch gewährleistet, dass Hordenhalter sowie Waferhorden sehr einfach und damit preisgünstig herstellbar sind.

Vorteilhafterweise weist die Waferhorde und/oder der Hordenhalter eine Zentriervorrichtung auf. Beim Beladen des Hordenhalters mit einer Waferhorde werden diese so aufeinander zentriert und justiert.

Das Einführen zwischen die dünnen Scheiben und auch das Entfernen der Distanzhalter bzw. des Kammes mit den Stiften aus einer solchen Waferhordenanordnung erfolgt durch eine erfindungsgemäß besonders vorteilhafte Kinematik. Über drei Bewegungsachsen wird der den Kamm aufweisende Distanzhalter-so zwischen die dünnen und damit verbogenen Wafer geführt, dass während des Einfahrens eine Berührung der Wafer weitestgehend vermieden wird. Bei der weiteren Bewegung des Kammes in die für den Herstellungsprozess vorgesehene Ausgangsposition werden die Wafer durch die Distanzstifte auf den erforderlichen Abstand gebracht und gehalten. Durch die sehr glatte, optimale Oberfläche der Distanzstifte des Kammes tritt bei dieser Bewegung eine minimale Reibung auf, so dass die Wafer zum einen durch den Herstellungsprozess nicht beschädigt werden und zum anderen eine gleichmäßige Prozessierung aller Wafer einer Horde erst möglich wird.

Die Erfindung wird nachfolgend anhand der in den Figuren der Zeichnung angegebenen Ausführungsbeispiele näher erläutert. Es zeigt dabei:
Figur 1 ein Seitenansicht und eine Frontalansicht einer erfindungsgemäßen Waferhorde;
Figur 2 in einer perspektivischen Ansicht den erfindungsgemäßen Hordenhalter zur Aufnahme einer nicht dargestellten Waferhorde;
Figur 3 zeigt einen Quarzkamm entsprechend Figur 2 in der Seitenansicht (a) und im Querschnitt (b);
Figur 4 die Seitenansicht eines erfindungsgemäßen Hordenhalters gemäß Figur 2 mit Waferhorde entsprechend Figur 1.

In den nachfolgenden Figuren sind - sofern nichts anderes angegeben ist - gleiche oder funktionsgleiche Elemente und Teile mit gleichen Bezugszeichen bezeichnet worden.

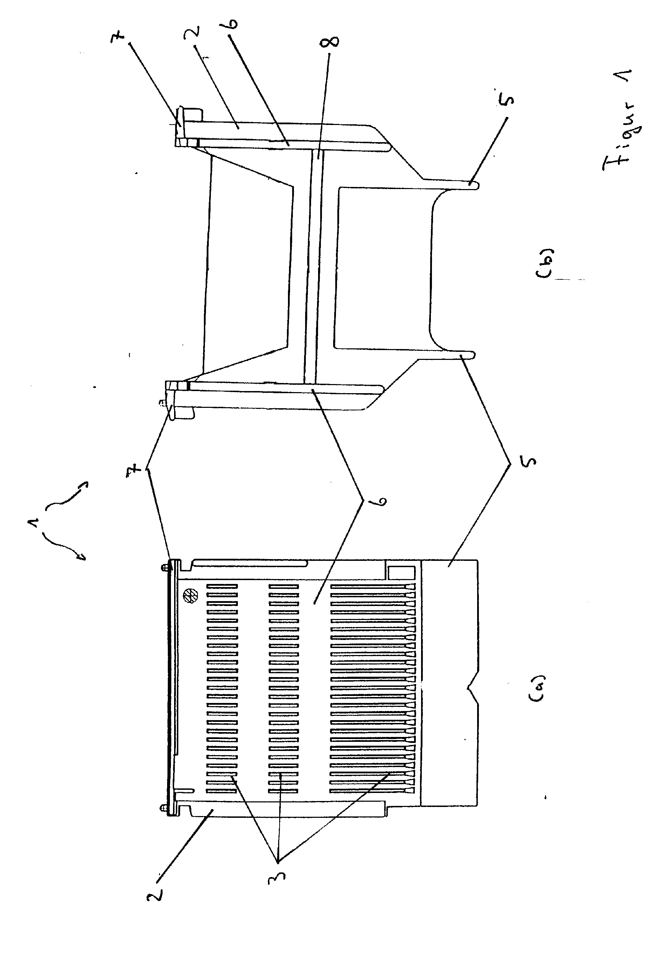

Figur 1 zeigt eine Seitenansicht (a) und eine Frontalansicht (b) einer mit Bezugszeichen 1 versehenen Waferhorde, die zur Aufnahme einer Vielzahl dünner Wafer ein Gehäuse 2 aufweist. Das Gehäuse 2 der Waferhorde 1 besteht aus zwei, durch stirnund rückseitige Querstege 8 miteinander verbundenen, geschlitzten Gehäusewänden 6. Die Gehäusewände 6 sind entsprechend der Anzahl der vorgesehenen Wafer an sich gegenüberliegenden Seiten mit Nuten als senkrechte, äquidistante Führungsschlitze 4 (Slots) versehen. Jeweils ein Schlitz dient beim Einführen der dünnen Wafer 4 in die Waferhorde 1 als Führung. Das Gehäuse 2 ist jeweils nach unten und noch oben hin und zudem auch von der Stirn- und der Rückseite her offen. Die Gehäusewände 6 weisen an ihrer Unterseite jeweils einen Steg 5 auf, der als Fuß fungiert und auf den die Waferhorde 1 abgestellt wird. Die Stege 5 fungieren ferner, wie nachfolgend noch erläutert wird, der Fixierung der Waferhorde 1. Die Gehäusewände 6 weisen ferner in ihrem oberen Bereich waagerecht verlaufende, mit der jeweiligen Gehäusewand 6 verbundene Stege 7 auf. Die Funktion der Stege 5, 7 wird ebenfalls später noch genauer erläutert.

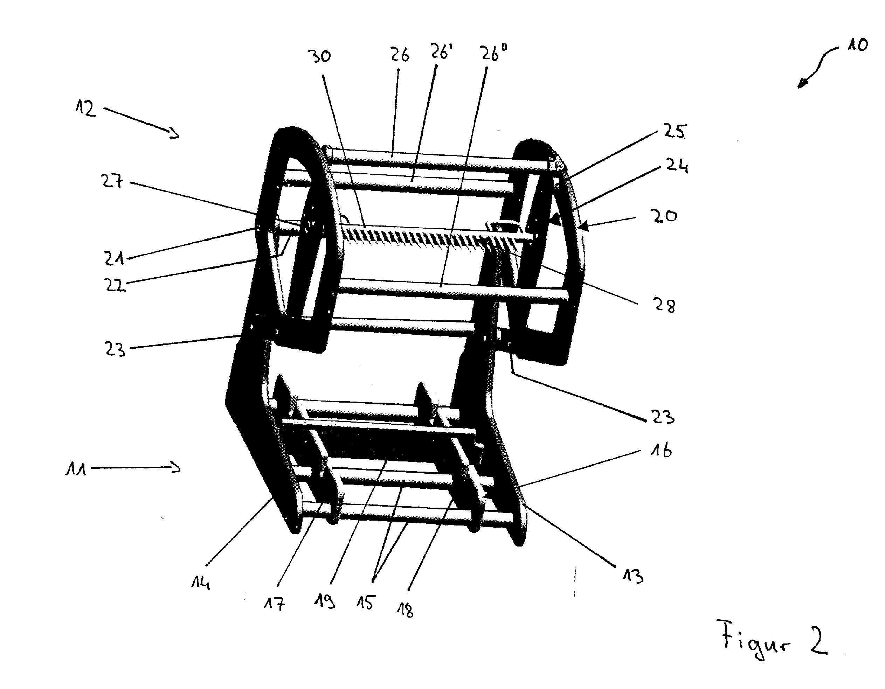

Figur 2 zeigt in einer perspektivischen Ansicht den erfindungsgemäßen Hordenhalter 10 zur Aufnahme einer Waferhorde 1 entsprechend Figur 1. Der Hordenhalter 10 besteht aus einem feststehenden Teil 11 (Stativ) sowie einer daran schwenkbar angeordneten Schwenkvorrichtung 12.

Das Stativ 11 besteht aus zwei parallel zueinander angeordneten, im wesentlichen winkelförmig ausgebildeten Teilen 13, 14. Zwischen den Winkelteile 13, 14 sind starr mit den Winkelteilen 13, 14 verbundene Querstäben 15 vorgesehen. Im unteren Bereich des Stativs 11 sind zwei Hordenzentrierteile 16, 17 vorgesehen. Die Hordenzentrierteile 16, 17 sind starr mit Querstäben 15 im unteren Bereich des Stativs 11 verbunden und parallel zu den Winkelteilen 13, 14 ausgerichtet. Die Hordenzentrierteile 16, 17 weisen nach oben gerichtete Kerben 18 auf, in die die senkrechten Stege 5 der vlaferhorde 1 entsprechend Figur 1 einsetzbar sind. Die Hordenzentrierteile 16, 17 sowie die darin vorgesehenen Kerben 18 dienen der Zentrierung sowie Fixierung der Waferhorde 1. Im unteren Bereich des Stativs 11 ist ferner ein Auflagesteg 19 vorgesehen. Der Auflagesteg 19 ist parallel zu den Querstäben 15 angeordnet und fest mit den Hordenzentrierteilen 16, 17 verbunden. Der Auflagesteg 19 dient der Auflage bzw. dem Anschlag der in der Waferhorde 1 angeordneten Wafer 4.

Die Schwenkvorrichtung 12 besteht im wesentlichen aus drei, um drei Achsen bewegbare Teile. Die Schwenkvorrichtung 12 weist zunächst einen im wesentlichen kreisringförmigen Schwenkarm 20 auf. Der Schwenkarm 20 ist an einer ersten Achse 21, die an dem nach oben gerichteten Ende der Winkelteile 13, 14 angeordnet ist, schwenkbar gelagert. Im unteren Bereich eines jeweiligen Schwenkarms 20 ist an einer zweiten Achse 23 jeweils ein Kammhalter 24 vorgesehen. Der Kammhalter 24 weist die Form eines nach oben gerichteten, beweglichen Armes auf, der entlang des oberen Bereiches eines jeweiligen Schwenkarmes 20 zwischen Anschlägen 25 hin und her bewegbar ist. Zum Zwecke der gegenseitigen Kopplung sowie Stabilisierung der Schwenkarme 20 und Kammhalter 24 sowie zu deren manueller Handhabung sind starr angeordnete Querstäbe 26 zwischen den jeweiligen Schwenkarmen 20 bzw. Kammhaltern 24 angeordnet. Ferner ist ein über eine dritte Achse 27 drehbar gelagerter Quarzkamm 28 vorgesehen. Die dritte Achse 27 des Quarzkammes ist oberhalb der zweiten Achse 23 an den Kammhalter 24 drehbar gelagert. An dem Quarzkamm 28 sind Griffe 29, über die der Quarzkamm 28 manuell bewegbar ist, angebracht.

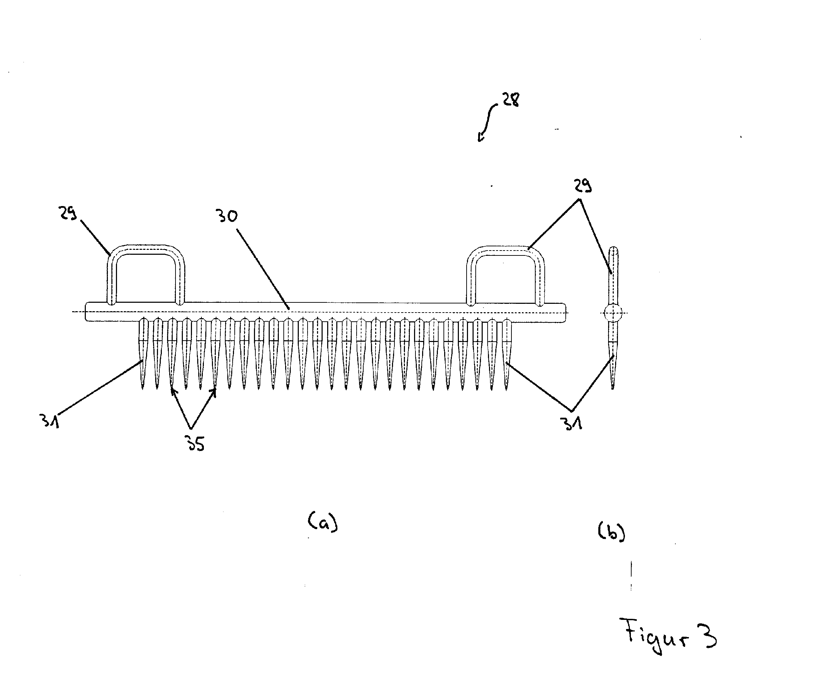

Figur 3 zeigt einen Ausschnitt eines Quarzkammes 28 entsprechend Figur 2. Der Quarzkamm 28 weist einen Quersteg 30 auf, der typischerweise zugleich die dritte Drehachse 27 bildet. Von dem Quersteg 30 des Quarzkammes 28 stehen eine Vielzahl von Stiften 31 ab. Die Stifte 31 weisen eine in etwa konische, zu den Stiftspitzen 35 der Stifte 31 zulaufende Form auf.

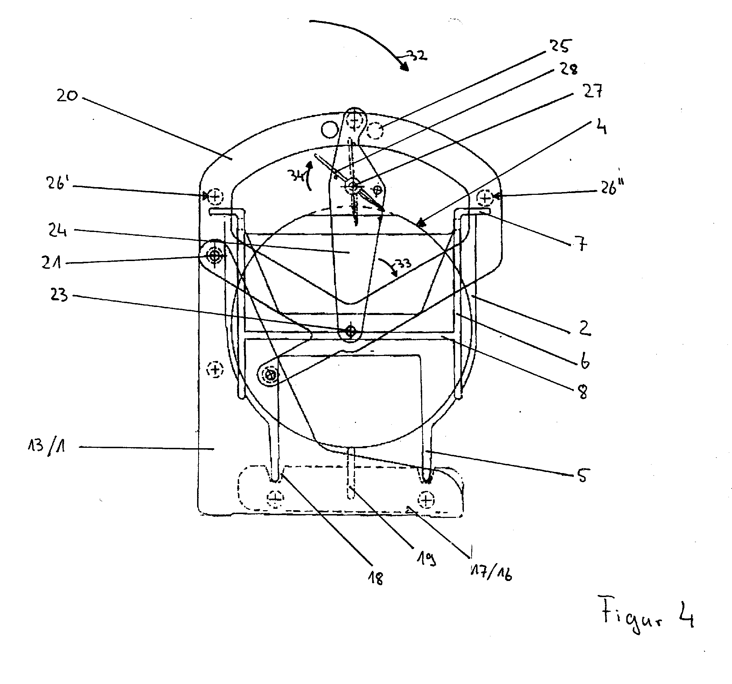

Anhand von Figur 4 wird nachfolgend der Bewegungsmechanismus der über drei Drehachsen 21, 23, 27 drehbar gelagerten Teile 20, 24, 27 der Schwenkvorrichtung 12 erläutert. Figur 4 zeigt in der Seitenansicht die mit Wafern 4 gefüllte Waferhorde 1, deren senkrechte Stege 5 in die dafür vorgesehenen Kerben 18 der Hordenzentrierteile 16, 17 und somit im Hordenhalter 10 angeordnet sind. Die Wafer 4 liegen auf dem Auflagesteg 19 auf. Damit die Stifte 31 des Quarzkammes 28 zwischen den einzelnen Wafer 4 als Distanzhalter fungieren können, wird zunächst der Schwenkarm 20 um die erste Drehachse 21 in Drehrichtung 32 geschwenkt. Der Schwenkarm 20 wird so lange in Richtung 32 gedreht, bis die Querstäbe 26', 26'' in Anlage zu den waagerechten Stegen 7 der Waferhorde 1, die als Anschlag dienen, gelangen. Anschließend wird der Kammhalter 24 in Drehrichtung 33 um die zweite Drehachse 23 gedreht, bis der Kammhalter 24 in Anschlag zu dem Anschlag 25 gelangt. Schließlich wird der Quarzkamm 28 in Drehrichtung 24 um die dritte Drehachse 27 so gedreht, dass die Stifte 31 des Quarzkammes 28 als Distanzhalter jeweils zwischen zwei Wafern 4 gelangt. Jeweils ein Wafer 4 wird dabei zwischen zwei Stifte 31 eingeklemmt und damit fixiert. Durch den eben beschriebenen Bewegungsvorgang werden die Wafer 4 lediglich von seitlichen Oberfläche der Stifte 31 berührt, nicht jedoch von den Stiftspitzen 35.

Schließlich wird der Quarzkamm 28 in Drehrichtung 24 um die dritte Drehachse 27 so gedreht, dass die Stifte 31 des Quarzkammes 28 als Distanzhalter jeweils zwischen zwei Wafern 4 gelangt. Durch die konische Form der Stifte 31 wird mithin gewährleistet, dass ein Wafer 4 gewissermaßen zwischen jeweils zwei Stifte 31 eingeklemmt und damit fixiert wird. Die in dem Hordenhalter 10 angeordnete und fixierte Waferhorde 1 mit den darin enthaltenen Wafer 4 kann nun zur weiteren nasschemischen Prozessierung behandelt werden. Beispielsweise können die Wafer 4 nun nasschemisch geätzt werden und anschließend gereinigt und getrocknet werden.

In dem vorstehenden Ausführungsbeispiel wurde der Beladevorgang des Hordenhalters 10 mit einer Waferhorde 1 dargelegt. Der Entladevorgang erfolgt hier äquivalent in umgekehrter Richtung, d. h. zunächst wird der Quarzkamm 28 entgegen der Drehrichtung 34 herausgeschwenkt. Anschließend werden der Kammhalter 24 und dann Schwenkarm 20 entgegen den Drehrichtungen 33 bzw. 32 zurückgeschwenkt. Die Waferhorde 1 kann dann wieder aus dem Hordenhalter 10 entnommen werden.

In dem vorstehend dargestellten Ausführungsbeispiel werden der Schwenkarm 20, der Kammhalter 24, sowie der Quarzkamm 28 manuell bewegt. Selbstverständlich wäre es auch denkbar, dass der Bewegungsmechanismus dieser Teile 20, 24, 28 automatisiert ist.

In dem vorstehenden Ausführungsbeispiel wurde ein eigens zur Aufnahme einer Waferhorde 1 ausgebildeter Hordenhalter 10 beschrieben. Die Erfindung sei jedoch nicht auf eine derartige Ausführung beschränkt. Vielmehr könnte der als Distanzhalter fungierende Quarzkamm 28 auch fest mit der Waferhorde 1 verbunden sein und beispielsweise über eine Schwenkvorrichtung zwischen die einzelnen dünnen Wafer 4 einschwenkbar sein. Darüber hinaus müssen die Stifte 31 des Quarzkammes 28 nicht notwendigerweise starr mit diesem verbunden sein, sondern könnten auch einzeln zwischen die einzelnen dünnen Wafer einschwenkbar sein, wenngleich dies aus Handhabungsgründen nicht so vorteilhaft und effektiv ist.

In dem vorstehenden Ausführungsbeispiel wurde der Aufbau und die Funktion der Waferhorde sowie des Hordenhalter zur Aufnahme und Handhabung dünner Wafer dargelegt. Die Erfindung sei jedoch nicht ausschließlich auf dünne Wafer beschränkt, sondern ist selbstverständlich auch bei nicht dünngeschliffenen Wafern vorteilhaft einsetzbar.

Zusammenfassend kann festgestellt werden, dass durch das Bereitstellen von Distanzhaltern, welche zwischen benachbarten dünne Wafer einer Waferhorde angeordnet werden, auf einfache, jedoch nichts desto Trotz sehr effektive Weise eine Fixierung und ein Stützen dieser Wafer gewährleistet wird, wodurch vorteilhafterweise sämtliche dünne Wafer der Waferhorde gleichmäßig prozessierbar werden, ohne dass die Nachteile von Anordnungen nach dem Stand der Technik in Kauf genommen werden müssen.

Die Erfindung sei nicht ausschließlich auf das Ausführungsbeispiel der Figuren 1 bis 4 beschränkt. Vielmehr lässt sich die vorliegende Erfindung selbstverständlich im Rahmen des fachmännischen Handelns und Wissens in geeigneter Weise abwandeln und modifizieren.

### Bezugszeichenliste

- 1: Waferhorde
- 2: Gehäuse
- 3: (Führungs-)Schlitze, Nuten
- 4: Wafer
- 5: (senkrechte) Stege
- 6: Gehäusewände
- 7: (waagerechte) Stege
- 8: Querstege
- 10: Hordenhalter
- 11: Stativ
- 12: Schwenkvorrichtung
- 13, 14: Winkelteile
- 15: Querstäbe
- 16, 17: Hordenzentrierteile
- 18: Kerben
- 19: Auflagesteg
- 20: Schwenkarm
- 21: erste Drehachse
- 22: drehbarer Quersteg
- 23: zweite Drehachse
- 24: Kammhalter
- 25: Anschlag
- 26, 26', 26' ': starre Querstäbe
- 27: dritte Querachse
- 28: Quarzkamm
- 29: Griffe
- 30: Quersteg des Quarzkammes
- 31: Stifte
- 32, 33, 34: Drehrichtungen
- 35: Stiftspitzen

## Patentansprüche

1. Hordenanordnung
mit einer Waferhorde (1) zur Aufnahme und Transport einer Vielzahl von Wafern (4) für nasschemische Prozesse in der Halbleitertechnologie, die ein Gehäuse (2) aufweist, welches zwei miteinander durch Stege (8) verbundene, entsprechend der Anzahl der vorgesehenen Wafer (4) an sich gegenüberliegenden Seiten mit senkrechten, äquidistanten Führungsschlitzen-(3) versehene Gehäusewände (6) umfasst,
mit Distanzhaltern (28, 31), die jeweils bei der mit Wafern (4) beladenen Waferhorde (1) derart zwischen die Wafer (4) bewegbar sind, dass benachbarte Wafer (4) von einem Distanzhalter (31) beabstandet und gestützt sind.

2. Hordenanordnung nach Anspruch 1,
**dadurch gekennzeichnet, dass** ein Hordenhalter (10) vorgesehen ist, der der Aufnahme mindestens einer Waferhorde (1) dient.

3. Hordenanordnung nach einem der vorstehenden Ansprüche,
**dadurch gekennzeichnet, dass** eine Schwenkvorrichtung (12) vorgesehen ist, mittels der die Distanzhalter (28, 31) beim Be- und Entladevorgang der Waferhorde (1) in eine Position außerhalb der Waferhorde (1) derart schwenkbar sind, dass ein ungehindertes Be- und Entladen der Waferhorde (1) mit Wafern (4) möglich ist, und mittels der bei einer mit Wafern (4) beladenen Waferhorde (1) die Distanzhalter (28, 31) zwischen benachbarte Wafer (4) schwenkbar sind.

4. Hordenanordnung nach Anspruch 3,
**dadurch gekennzeichnet, dass** die Schwenkvorrichtung (12) drei, um jeweils eine Achse (21, 23, 27) drehbare Teile (20, 24, 28) aufweist, wobei ein erstes drehbares Teil (20) an einem feststehenden Teil (11) der Waferhorde (1) oder des Hordenhalters (10) gelagert ist, wobei ein zweites drehbares Teil (24) an dem ersten Teil (20) drehbar gelagert ist und wobei das dritte Teil (28) am zweiten Teil (24) drehbar gelagert ist und die Distanzhalter (28, 31) aufweist.

5. Hordenanordnung nach einem der Ansprüche 3 oder 4,
**dadurch gekennzeichnet, dass** ist die Schwenkvorrichtung (12) von der Waferhorde (1) abnehmbar vorgesehen.

6. Hordenanordnung nach einem der vorstehenden 3 - 5,
**dadurch gekennzeichnet, dass** eine Antriebseinheit sowie eine programmgesteuerte Einheit vorgesehen ist, mittels der der Bewegungsvorgang der Schwenkvorrichtung (12) programmgesteuert abläuft.

7. Hordenanordnung nach einem der vorstehenden Ansprüche,
**dadurch gekennzeichnet, dass** der Distanzhalter (28, 31) die Form eines Kammes aufweist, wobei der Kamm mehrere Stifte (31) enthält, die die Funktion eines Abstandshalter und einer Stütze benachbarter Wafer (1) inne haben.

8. Hordenanordnung nach einem der vorstehenden Ansprüche,
**dadurch gekennzeichnet, dass** die Distanzhalter (31) aus gezogenem Quarzglas ausgebildet sind.

9. Hordenanordnung nach einem der vorstehenden Ansprüche,
**dadurch gekennzeichnet, dass** die Oberfläche der Distanzhalter (31) eine Rauhigkeit (Ra) von weniger als 0,012 µm, insbesondere von weniger als 0,006 µm, aufweist.

10. Hordenanordnung nach einem der vorstehenden Ansprüche,
**dadurch gekennzeichnet, dass** die Distanzhalter (31) eine spitze Form aufweisen.

11. Hordenanordnung nach einem der vorstehenden Ansprüche,
**dadurch gekennzeichnet, dass** die Distanzhalter (31) eine konische Form aufweisen.

12. Hordenanordnung nach einem der vorstehenden Ansprüche,
**dadurch gekennzeichnet, dass** die Wafer (4), für die die Waferhorde (1) ausgelegt ist, als dünne Wafer (4) ausgebildet sind, die eine Waferdicke von weniger als 150 µm, insbesondere von weniger als 80 µm, aufweisen.

13. Hordenanordnung nach einem der vorstehenden Ansprüche,
**dadurch gekennzeichnet, dass** das Gehäuse (2; 11, 12) der Waferhorde (1) und/oder des Hordenhalters (10) zumindest teilweise aus Polyetheretherketon (PEEK) besteht

14. Hordenanordnung nach einem der vorstehenden Ansprüche,
**dadurch gekennzeichnet, dass** die Waferhorde (1) und/oder der Hordenhalter (10) eine Zentriervorrichtung (7; 16, 17) aufweisen, die beim Beladen des Hordenhalters (10) mit einer Waferhorde (1) diese aufeinander zentrieren und justieren.

15. Hordenhalter (10) für eine Hordenanordnung nach einem der vorstehenden Ansprüche,
mit einem Gehäuse (11, 12), welches der Aufnahme mindestens einer Waferhorde (1) für nasschemische Prozesse dient, wobei das Gehäuse (11, 12) eine schwenkbare Schwenkvorrichtung (12), an der Distanzhalter (28, 31) angebracht sind, aufweist und wobei die Distanzhalter (28, 31) mittels der Schwenkvorrichtung (12) in die Richtung der Waferhorde (1) sowie von der Waferhorde (1) weg bewegbar ist.

16. Verfahren zum Fixieren und Stützen von in einer Waferhorde (1) nach einem der Ansprüche 1 bis 14 angeordneter Wafer (4) zum Zweck der nasschemischen Prozessierung, mit folgenden Verfahrensschritten:
(A) Eine mit einer Vielzahl von Wafer (4) beladenen Waferhorde (1) sowie aus der Waferhorde (1) herausgeschwenkte Distanzhalter (28, 31) werden bereitgestellt;
(B) Mittels einer Schwenkvorrichtung (12) werden die Distanzhalter (28, 31) in Richtung der Waferhorde (1) geschwenkt;
(C) Distanzhalter (28, 31) werden zwischen benachbarte Wafer (4) geschwenkt und in Anlage mit diesen gebracht;
(D) Nach dem halbleitertechnologischen Prozessieren der in der Waferhorde (1) angeordneten Wafer (4) werden die Distanzhalter (28, 31) wieder aus der Waferhorde (1) herausgeschwenkt.

17. Verfahren nach Anspruch 16,
**dadurch gekennzeichnet, dass** die Schwenkvorrichtung (12) sowie die Distanzhalter (28, 31) während der Verfahrensschritte (B) und (D) eine Bewegung derart vornehmen, dass eine Berührung der Oberfläche der Wafer (4) durch Teile der Schwenkvorrichtung (12) und/oder des Distanzhalters (28, 31) unterbleibt und dass eine Berührung der Wafer (4) lediglich im Verfahrensschritt (C) durch Stifte (31) der Distanzhalter (28, 31) erfolgt.

18. Verfahren nach einem der Ansprüche 16 und 17,
**dadurch gekennzeichnet, dass** der Bewegungsvorgang der Schwenkvorrichtung (12) während der Verfahrensschritte (B) - (D) programmgesteuert verläuft.

19. Verfahren nach einem der Ansprüche 16 bis 18,
**dadurch gekennzeichnet, dass** die Schwenkvorrichtung (12) aus drei schwenkbaren Teilen (20, 24, 28) besteht, wobei ein erstes drehbares Teil (20) drehbar an einem feststehenden Teil (11) gelagert ist, wobei ein zweites drehbares Teil (24) am ersten Teil (20) drehbar gelagert ist, wobei ein drittes drehbares Teil (28), welches die Distanzhalter (28, 31) aufweist, am zweiten Teil (24) drehbar gelagert ist, wobei für die Verfahrensschritte (B) und (C) nacheinander das erste Teil (20), das zweite Teil (24) und schließlich das dritte Teil (28) jeweils in ihre Drehrichtungen (32, 33, 34) bis zum Erreichen jeweils einer Endposition gedreht werden.

20. Verfahren nach Anspruch 19,
**dadurch gekennzeichnet, dass** die Endposition der drehbaren Teile (20, 24, 28) durch jeweils mindestens einen Anschlag (25) festgelegt wird.

21. Verfahren nach einem der Ansprüche 16 bis 20,
**dadurch gekennzeichnet, dass** die Schwenkvorrichtung (12) während der Prozessierung der Wafer (4) von der Waferhorde (1) abgenommen wird.
